# EUROPEAN PATENT APPLICATION

(11) **EP 2 908 396 A1**
(43) Date of publication of application: **19.08.2015**
(21) Application number: 14155229.9
(22) Date of filing: 14.02.2014
(51) Int. Cl.: H02G 3/22, H01B 17/30, H01R 13/533

(54) **Penetrator device, wall device to be penetrated, penetrator assembly and method for establishing a penetration**

(71) Applicant: Siemens Aktiengesellschaft, 80333 München (DE)
(72) Inventor: Volent, Kjetil Zsolt, 7022 Trondheim (NO)

(57) **Abstract**

It is described a penetrator assembly (10) for high pressure and/or subsea applications, comprising a penetrator device (40) and a wall device (20) having a penetration opening (26) adapted to operatively receive the penetrator device (40), wherein a first flange or shoulder portion (52) is provided on the outer mantle surface (50) of the penetrator device (40) and a complementary second flange or shoulder portion (32) is provided on the inner mantle surface (30) of the penetration opening (26) in the wall device (20). The second flange or shoulder portion (32) can carry axial forces (84) caused by the action of high pressure (80) on the high pressure environment side (12) of the penetrator assembly (10) and transmitted by the penetrator device (40) to the wall device (20) via the first shoulder portion (52) contacting the second shoulder portion (32).

## Description

### Field of invention

The present invention relates to the field of high pressure and/or subsea penetrations, in which structure walls, such as walls in a high pressure and/or subsea environment are penetrated by a conductor, such as an electrical or optical conductor, from the side of a high pressure environment to the side of a low pressure environment. Namely, the present invention relates to a penetrator device, a wall device to be penetrated, a penetrator assembly comprising a wall device to be penetrated and a penetrator device, and to a method for establishing a penetration of a penetrator device through a wall device. Herein, the term "penetrator" or "penetration" refers to the passing of a conductor, such as an isolated electrical wire for conducting electric current, a sheathed optical fibre for conducting light or a flow line for conducting fluid flow, through a wall device, which separates a high pressure environment from a low pressure environment by means of a penetrator device, through which the conductor passes and which is mounted in a penetration opening of the wall device.

### Art Background

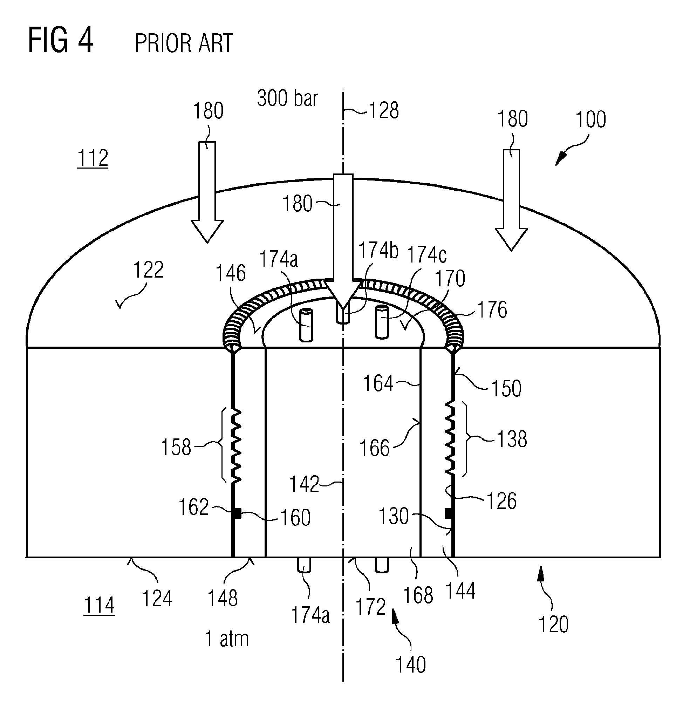

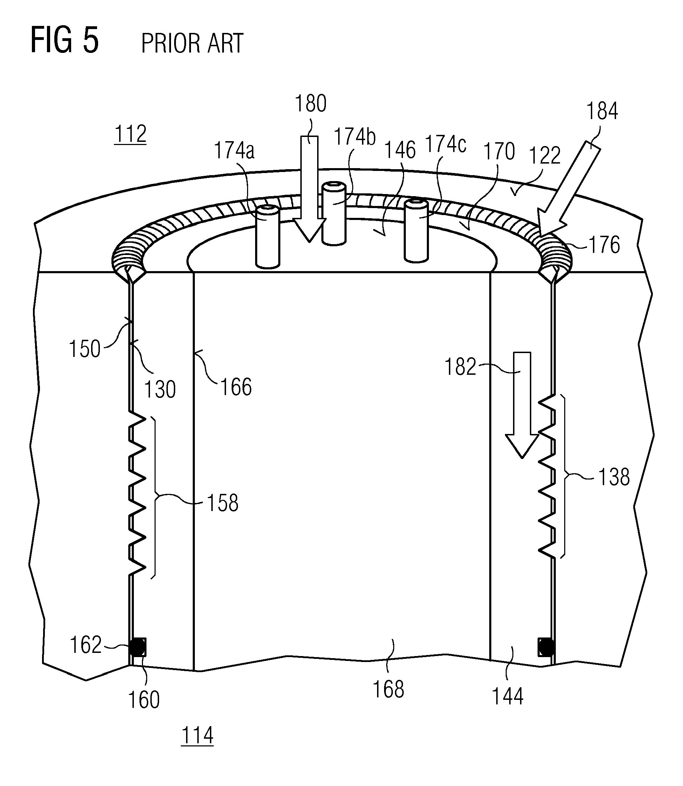

A conventional subsea penetrator assembly 100, as shown in Figures 4 and 5, comprises a penetrator 140 and a wall 120. The wall 120 comprises a penetration opening 126, which has an inner mantle surface 130 comprising a threaded portion 138 and in which the penetrator 140 is operatively received. The wall 120 may be the wall of a subsea structure and may be e.g. the lid of a container or the casing wall of an apparatus disposed in a subsea environment. The outside of the subsea structure may be a high pressure environment that is at a high pressure (e.g. up to 300 bar), while the inside of the structure may be a low pressure environment that is at a low pressure (e.g. close to or at atmospheric pressure of 1 atm). The penetrator 140 comprises a substantially cylindrical housing 144 having a cylindrical outer mantle surface 150 comprising a threaded portion 158 and an inner mantle surface 166 delimiting a passage 164, which extends axially from the high pressure environment side 122 to the low pressure environment side 124 and in which is received an insert 168, through which conductors 17a, 174b and 174c pass in a direction along an axis 142 of the penetrator 140.

In order to establish such a penetrator assembly 100 in place, a prefabricated penetrator 140 is inserted in the, e.g. predrilled, penetration opening 146 of a prefabricated wall 120 and is then screwed in place, whereby the threaded portion 158 of the outer mantle surface 150 of the housing 144 of the penetrator 140 engages with the threaded portion 138 of the inner mantle surface 130 of the penetration opening 126 in the wall 120, until the high pressure side surface 146 of the housing 144 is substantially flush with the high pressure side surface 122 of the wall 120. The threaded portions 138 and 158 are made very accurately, i.e. having very tight tolerances, so as to ensure that the penetrator 140 is held in place in the wall 120 with a minimum of, and preferably hardly any axial play. Then, a circumferential weld seam 176 is produced on the high pressure side along the circumferential edges of the high pressure side surface 122 of wall 120 and the high pressure side (first end) surface 146 of the penetrator 140. The weld seam 176 is a main sealing means for sealing the penetrator assembly 100 against high pressure and/or subsea environment and notably against the action of the high pressure that acts on the high pressure side surfaces 122 and 146. In addition, prior to inserting the penetrator 140 in the penetration opening 126, a seal 162, such as an O-ring, is put in a circumferential groove 160 made in the outer mantle surface 150 of the penetrator 140 and located preferably axially between the threaded portion 158 and the second end surface 148 on the low pressure side of the housing 144. When the penetrator 140 is screwed in place in the penetration opening 126, the seal 162 contacts the inner mantle surface 130 of the penetration opening 126 and functions as an additional sealing means.

The conventional design of a penetrator assembly 100 as shown in Figures 4 and 5 essentially relies on a well dimensioned welding and on the very accurateness of the threads 138, 158, which is intended to keep the penetrator 140 very precisely axially in place in the penetration opening 126 of the wall 120 and this eventually under the action of the high pressure present e.g. in the subsea environment, as depicted by the arrows 180 in Figures 4 and 5. Since the very precise axially keeping in place is difficult to achieve, high axial forces due to the high pressure action 180 act on the weld seam 176, for which forces the weld seam 176 is not designed for. This effect is known to cause microscopic cracks in the weld seam 176, which in turn may cause water intrusion into, for example, the gap between the outer mantle surface 150 of the penetrator 140 and the inner mantle surface 130 of the penetration opening 126 of the wall 120. The water intrusion may cause a decrease in the isolation, e.g. in an electrical isolation to such a level that electronic circuitry located at the low pressure side of the wall 120 may fail.

There may be a need in penetrator assemblies, namely in the penetrator device, to reduce the vulnerability of the welding, which is caused mainly by said crack formation. Accordingly, an object of the present invention is to improve the tightness and reliability of a present penetrator assembly, e.g. by reducing the vulnerability of the welding.

### Summary of the Invention

This need may be met and the object be achieved by the subject matter according to the independent claims.

According to a first aspect of the invention there is provided a penetrator device being for high pressure and/or subsea applications and adapted to be operatively received in a penetration opening of a wall device for high pressure and/or subsea applications, and being adapted to conductively penetrate the wall device from a high pressure environment side surface thereof to a low pressure environment side surface thereof. The penetrator device comprises: a housing centered around an axis and having a first end surface, a second end surface located substantially opposite to the first end surface, and an outer mantle surface adapted to cooperate with an inner mantle surface of the penetration opening. According to the invention, the outer mantle surface comprises a first flange resp. shoulder portion, at which the radius of the outer mantle surface decreases from a first radius to a second radius that is smaller than the first radius when going axially in the direction towards the second end surface, and which is axially located so as to be axially between the high pressure environment side surface and the low pressure environment side surface of the wall device, when the penetrator device is operatively received in the penetration opening of the wall device. Of course, the first flange resp. shoulder portion is axially located between the first and the second end surface of the housing.

The first end surface of the housing may be for being exposed to the high pressure environment and the second end surface of the housing may be for being exposed to the low pressure environment. The high pressure environment may comprise a higher pressure in comparison to a lower pressure of the low pressure environment.

The first flange or shoulder portion in the outer mantle surface of the penetrator device comprises surface portions, which are directed in the direction of the action of axial forces transmitted by the penetrator device consequent to the action of the high pressure acting on the penetrator device. These surface portions may abut against complementary surface portions of a complementary second flange or shoulder portion formed in the inner mantle surface of the penetrator opening of the wall device, in which the penetrator device is received, so that the abutment of the first shoulder portion against the second shoulder portion collects and carries the axial forces acting in the penetrator assembly. As a further result of the abutment of the first shoulder portion against the second shoulder portion, the penetrator device cannot undergo an axial movement anymore. Accordingly, the weld seam no longer has to withstand the forces due to the action of the high pressure and is allowed to act as a sealing only. The weld seam no longer has to serve as a carrier of pressure. In result, the tendency of crack formation in the weld seam is reduced, if not absent, due to the inventive design of the penetrator device comprising the first shoulder portion in its outer mantle surface abutting the second shoulder portion in the inner mantle surface of the penetration opening.

The conductor may be one of the following: an electrical line for conducting an electric current, a sheathed optical fiber for conducting light, and a flow line for conducting a fluid flow.

The outer mantle surface of the housing may comprise a threaded portion that is axially located between the first shoulder portion and the second end surface of the housing. The threaded portion acts to ensure that the penetrator device is screwed all the way into the penetration opening, until the first shoulder portion in the outer mantle surface of the penetrator device abuts against the complementary second shoulder portion in the complementary inner mantle surface of the penetration opening in the wall device.

Preferably, the first shoulder portion in the outer mantle surface of the penetrator device has a flat annular shape. In this case, the axial forces can be carried fully by the oppositely directed, complementary second shoulder portions in the inner mantle surface of the penetration opening.

Alternatively, the shoulder portion in the outer mantle surface of the penetrator device may have a conical shape. The conical shape of the shoulder portion may be more easily manufactured than a flat annular shape, while the conical shoulder portion is also capable to carry the axial forces acting on the penetrator device due to the action of the high pressure.

The outer mantle surface may comprise a circumferential groove that is adapted to receive a circumferential seal, such as an O-ring. The circumferential seal, carried by being received in the groove, provides a sealing against the penetration opening of the wall device, when the penetrator device is operatively received in the penetration opening of the wall device, and this eventually as an additional sealing to that achieved by the weld seam.

The first shoulder portion in the outer mantle surface may be complementary to a second shoulder portion provided in an inner mantle surface of the penetration opening of a wall device, e.g. according to the second aspect of the invention described below. The mutually complementary first and second shoulder portions are capable to carry the axial forces acting on the penetrator device relative to the wall device due to the action of the high pressure.

In the penetrator device, the housing may comprise an inner mantle surface surrounding a passage; and the penetrator device may further comprise an insert received in the passage and having a third end surface and a fourth end surface located substantially opposite to the third end surface; and at least one elongate conductor that is incorporated in the insert, extends at least from the third end surface to the fourth end surface and projects from both the third and the fourth end surfaces of the insert. In result, the conductor passes through the penetrator device, sealingly incorporated in the insert, and projects from both the high and low pressure environment side so that it can be extended as needed without necessity of any plug-and-socket connection. For example, the conductor may extend from the subsea high pressure environment up to the sea surface. On the opposite side of the wall device, the conductor may extend in the low pressure environment present within the wall device to any device being supplied with what is conducted by the conductor.

The first end surface of the housing and the third end surface of the insert may be adapted to be exposed to a high pressure and/or subsea environment. The second end surfaces of the housing and the fourth end surface of the insert may be adapted to be exposed to a low pressure environment. In that way, the penetrator device is suitable for high pressure and/or harsh subsea environment conditions.

According to a second aspect of the present invention, there is provided a wall device being for high pressure and/or subsea applications and having a penetration opening adapted to operatively receive a penetration device being for high pressure and/or subsea applications and adapted to conductively penetrate the wall device from a high pressure environment side surface thereof to a low pressure environment side surface thereof. The penetration opening is centered around an axis, extends from the high pressure environment side surface to the low pressure environment side surface, and comprises an inner mantle surface. The inner mantle surface comprises a second flange resp. shoulder portion, at which the radius of the inner mantle surface decreases from a third radius to a fourth radius that is smaller than the third radius when going axially in the direction toward the low pressure side surface, and which is axially located between the high pressure environment side surface and the low pressure environment side surface.

The second shoulder portion in the inner mantle surface of the penetration opening of the wall device interacts with the first shoulder portion provided on the outer mantle surface of the penetrator device, by carrying the axial forces due to action of the high pressure and transmitted by the penetrator device when the first shoulder portion of the penetrator device abuts against the complementary second shoulder portion in the inner mantle surface of the penetration opening.

The inner mantle surface may comprise a threaded portion that is axially located between the second shoulder portion and the low pressure environment side surface. The threaded portion on the inner mantle surface of the penetrator opening is complementary to and engages with the threaded portion on the outer mantle surface of the penetrator device, when the penetrator device is received in the penetration opening. Consequent to the mutual engagement of the threaded portions, the penetrator device is more accurately held in place and can be screwed into the penetration opening until a good contact is obtained between the mutually complementary first and second shoulder portions.

With the same advantages as in the penetrator device according the first aspect of the invention, the second shoulder portion in the penetration opening may have a flat annular shape, or may alternatively have a conical shape.

Also with the same advantages as in the penetrator device according the first aspect of the invention, the second shoulder portion in the inner mantle surface may be complementary to a first shoulder portion provided on the outer mantle surface of the housing of a penetrator device according to the first aspect of the invention described above.

According to a third aspect of the invention, there is provided a penetrator assembly being for high pressure and/or subsea applications and comprising a wall device according to the first aspect of the invention and a penetrator device according to the second aspect of the invention. In the penetrator assembly, the penetrator device is operatively received in the penetration opening of the wall device, and adapted to conductively penetrate the wall device from a high pressure environment side surface thereof to a low pressure environment side surface thereof.

The penetrator assembly achieves the same technical advantages as the penetrator device according to the first aspect and the wall device according to the second aspect of the invention.

The penetrator assembly may further comprise a weld seam that is arranged at the high pressure environment side and extends circumferentially so as to bridge the first end surface of the housing of the penetrator device and the high pressure environment side surface of the wall device. The circumferential weld seam provided on the high pressure side surface of the penetrator assembly provides the main sealing function, which no longer tends to deteriotate due to micro-crack formation, contrary to the prior art.

Alternatively or in addition, the penetrator assembly may further comprise a circumferential seal, such as an O-ring, which is received in a circumferential groove in the outer mantle surface of the housing of the penetrator device so as to seal against the inner mantle surface of the penetration opening of the wall device, when the penetrator device is operatively received in the penetration opening of the wall device. The seal and the groove are preferably axially located between the first shoulder portion of the penetrator device and the low pressure environment side surface of the wall device. The seal provides additional sealing to the sealing action of the first and second shoulder portions in abutting contact and the sealing action of the circumferential weld seam.

According to a fourth aspect of the invention, there is provided a method for mounting a penetrator device for high pressure and/or subsea applications in a penetration opening of a wall device for high pressure and/or subsea applications, wherein the wall device has at least one penetration opening adapted to receive the at least one penetration device so that the wall device is conductively penetrated from a high pressure environment side surface thereof to a low pressure environment side surface thereof by the at least one penetration device. The method comprises the steps of:
(a) providing a wall device comprising a penetration opening that is centered around an axis, extends from a high pressure environment side surface to a low pressure environment side surface of the wall device, and has an inner mantle surface;
(b) producing, on the inner mantle surface of the penetration opening, (i) a second flange resp. shoulder portion, at which the radius of the inner mantle surface decreases from a third radius to a fourth radius that is smaller than the third radius when going axially in the direction toward the low pressure side surface, and which is axially located between the high pressure environment side surface and the low pressure environment side surface, and (ii) a threaded portion;
(c) providing a penetrator device comprising a housing centered around an axis and having a first end surface, a second end surface located substantially opposite to the first end surface, and an outer mantle surface adapted to cooperate with the inner mantle surface of the penetration opening;
(d) producing, in the outer mantle surface of the housing of the penetrator device, (iii) a first flange resp. shoulder portion, at which the radius of the outer mantle surface decreases from a first radius to a second radius that is smaller than the first radius when going axially in the direction towards the second end surface, and which is axially located between the first and the second end surface of the housing and which is adapted to be axially located between the high pressure environment side surface and the low pressure environment side surface of the wall device, when the penetrator device is operatively received in the penetration opening of the wall device, and (iv) a threaded portion;
(e) positioning the penetrator device at the high pressure environment side of the wall device and aligned along the axis of the penetration opening of the wall device; and
(f) screwing the penetration device into the penetration opening of the wall device, whereby the threaded portion on the outer mantle surface of the housing of the penetrator device engages with the threaded portion on the inner mantle surface of the penetration opening, until the first flange resp. shoulder portion on the outer mantle surface of the penetration device contacts the second flange resp. shoulder portion on the inner mantle surface of the penetration opening.

In the penetrator device provided in step (c), the housing may comprise an inner mantle surface surrounding a passage, and the penetrator device may further comprise an insert received in the passage and having a third end surface and a fourth end surface located substantially opposite to the third end surface; and at least one elongate conductor that is incorporated in the insert, extends at least from the third to the fourth end surface and projects from both the third and the fourth end surface of the insert.

It has to be noted that embodiments of the invention have been described with reference to different subject matters. In particular, some embodiments have been described with reference to apparatus type claims whereas other embodiments have been described with reference to method type claims. However, a person skilled in the art will gather from the above and the following description that, unless other notified, in addition to any combination of features belonging to one type of subject matter, also any combination between features relating to different subject matters, in particular between features of the apparatus type claims and features of the method type claims, is considered as to be disclosed with this application.

### Brief Description of the Drawings

The aspects defined above and further aspects of the present invention are apparent from examples of embodiment to be described hereinafter and are explained with reference to the examples of embodiment. The invention will be described in more detail hereinafter with reference to examples of embodiments but to which the invention is not limited.
Figure 1 shows a first embodiment of a penetrator assembly according to the invention in perspective and partially sectional view.
Figure 2 shows an enlarged portion of the penetrator assembly shown in Figure 1, illustrating the action of high pressure and related forces.
Figure 3 shows a second embodiment of a penetrator assembly according to the invention in perspective and partially sectional view.
Figure 4 shows an embodiment of a conventional penetrator assembly in perspective and partially sectional view.
Figure 5 shows an enlarged portion of the conventional penetrator assembly shown in Figure 4, illustrating the action of high pressure and related forces.

### Detailed Description

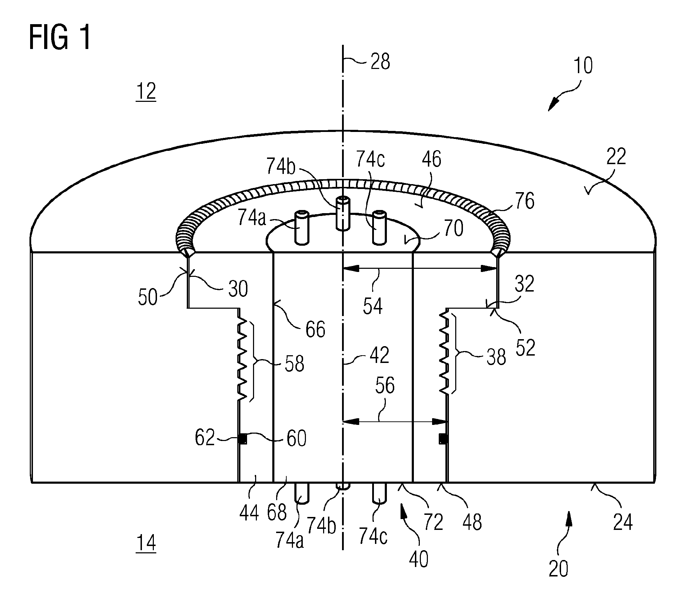

The illustrations in the drawings are schematically. It is noted that in Figures 1 to 3, similar or identical elements are provided with the same reference signs.

Fig. 1 shows a first embodiment of a penetrator assembly 10 according to the invention. The penetrator assembly 10 comprises a wall device 20 having a penetration opening 26, and a penetrator device 40 which is, in the case of Fig. 1, received in the penetration opening 26. The penetrator assembly 10 is for high pressure and/or subsea applications and is used to guide resp. let pass one or more conductors 74a, 74b and 74c therethrough so as to extend from a side of a high pressure environment 12 to a side of a low pressure environment 14, which is located on the opposite side of the wall device 20 with respect to the high pressure environment 12. The high pressure environment 12 may be at subsea level and may be subject to pressures of up to 300 bar and further harsh parameters of such an environment, such as saline water. The low pressure environment 14 may be the interior of the wall device 20. The wall device 20 may be, or may be part of, a subsea device, such as a pump, a compressor, an electric converter, an electric switching station or a measurement station, all of which may comprise electric circuitry requiring supply of electric current or electric control signals, or may comprise devices that communicate with the outside via optical signals guided by optical fibres.

The penetrator device 40 comprises a housing 44 centered around an axis 42 and having a first end surface 46, a second end surface 48 located opposite to the first end surface 46, an outer mantle surface 50 adapted to cooperate with the penetration opening 26 and an inner mantle surface 66 surrounding a passage 64. The axis 42 extends substantially perpendicular to the first and second end surfaces 46 and 48. The penetrator device 40 further comprises an insert 68 received in the passage 64 and having a third end surface 70 and a fourth end surface 72 located opposite to the third end surface 70. Incorporated in the insert 68, the penetrator device 40 further comprises at least one, in the present case three, elongate conductors 74a, 74b, 74c, which extend from the third end surface 70 to the fourth end surface 72 and project from both the third and the fourth end surfaces 70, 72 of the insert 68.

The outer mantle surface 50 of the housing 44 comprises a first shoulder portion 52, at which the radius of the outer mantle surface 50 decreases from a first radius 54 present at the high pressure environment side 12 to a second radius 56 that is smaller than the first radius 54 when going in the direction from the first end surface 46 to the second end surface 48 and that is present on the side of the low pressure environment 14. The first shoulder portion 52 is axially, i.e. with respect to the axis 42, located between the first end surface 46 and the second end surface 48 of the housing and, as is important for the invention, notably axially located so as to be axially between the high pressure environment side surface 22 and the low pressure environment side surface 24 of the wall device 20, when the penetrator device 40 is operatively received in the penetration opening 26 of the wall device 20.

The outer mantle surface 50 of the housing 44 further comprises a threaded portion 58, which is located axially between the first shoulder portion 52 and the second end surface 48 in the embodiment of Fig. 1.

The insert 68 is traversed in the axial direction by the three conductors 74a, 74b, 74c, which each extend from the third end surface 70 to the fourth end surface 72 of the insert 68. The conductors 74a, 74b, 74c may be any of an isolated electric line for conducting an electric current, a sheathed optical fibre for conducting light and a flow conduit for conducting fluid flow.

The wall device 20 has the penetration opening 26, which is adapted to operatively receive the penetrator device 40. In the embodiments of a penetrator assembly 10 shown in the Figs. 1 to 3, the penetrator device 40 is operatively received in the penetration opening 26 of the wall device 20. The penetration opening 26 is centered around an axis 28, which extends substantially perpendicular to the high and low pressure environment side surfaces 22 and 24 of the wall device 20. The penetration opening 26 extends from said high pressure environment side surface 22 to said low pressure environment side surface 24 and comprises an inner mantle surface 30.

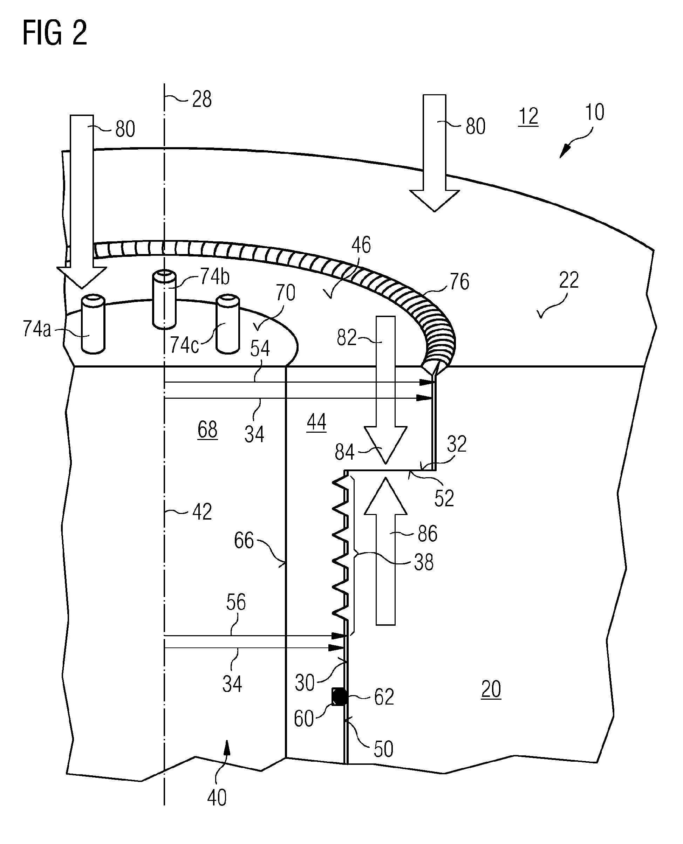

The inner mantle surface 30 comprises a second shoulder portion 32, at which the radius of the inner mantle surface 30 decreases from a third radius 34 to a fourth radius 36 that is smaller than the third radius when going in the direction from the high pressure environment side surface 22 towards the low pressure environment side surface 24. The third radius 34 is the radius present at the side of the high pressure environment 12 and the fourth radius 36 is the radius present at the side of the low pressure environment 14 of the wall device 20, see notably Fig. 2. The second shoulder portion 32 of the inner mantle surface 30 is axially located between the high pressure environment side surface 22 and the low pressure environment side surface 24 of the wall device 20.

The inner mantle surface 30 further comprises a threaded portion 38, which is axially located between the shoulder portion 32 and the low pressure environment side surface 24. The threaded portion 38 on the inner mantle surface 30 cooperates and engages the threaded portion 58 on the outer mantle surface 50 of the housing 44 of the penetrator device 40, when the penetrator device 40 is operatively received in the penetration opening 26 of the wall device 20. In order to insert the penetrator device 40 in the penetration opening 26 of the wall device 20, the penetrator device 40 is positioned at the side of the high pressure environment 12 of the wall device 20 and aligned along the axis 28 of the penetration opening 26, and is then screwed into the penetration opening 26, whereby the threaded portion 58 in the outer mantle surface 50 starts to engage with the threaded portion 38 in the inner mantle surface 30 of the penetration opening 26. The screwing of the penetrator device 40 into the penetration opening 26 is continued, until the first shoulder portion 52 in the outer mantle surface 50 of the penetrator device 40 contacts the second shoulder portion 32 in the inner mantle surface 30 of the penetration opening 26 and further until there is a good, tight contact between the mutually abutting first and second shoulder portions 52 and 32.

The penetrator assembly 10 further comprises a weld seam 76, which is produced circumferentially along the edge of the outer mantle surface 50 at the side of the high pressure environment 12 and the edge of the inner mantle surface 30 of the penetration opening 26 at the side of the high pressure environment 12, so as to bridge a gap that may be or is present between the two edges. Hence, the weld seam 76 bridges circumferentially from the first end surface 46 of the housing 44 to the high pressure environment side surface 22 of the wall device 20. The weld seam 76 is, of course, applied after the penetrator device 40 has been screwed into the penetration opening 26 of the wall device 20 as explained above. The function of the weld seam 76 is to seal the gap, which circumferentially extends between the outer mantle surface 50 of the housing 44 and the inner mantle surface 30 of the penetration opening 26.

The penetrator device 40 further comprises a circumferential groove 60, which is arranged in the outer mantle surface 50 in a portion thereof that is located axially between the first shoulder portion 52 and the second end surface 48. In the embodiment shown in Fig. 1, the groove 60 is namely located axially between the threaded portion 58 and the second end surface 48. In the groove 60, there is provided a seal 62, such as an O-ring, which has the function to seal against the inner mantle surface 30 of the penetration opening 26.

The inventive function of the first and second shoulder portions 32 and 52 is explained with reference to Fig. 2. The high pressure present in the side of the high pressure environment 12 acts on the surface 22 of the wall device 20 and on the first and third end surfaces 46 and 70 of the penetrator device 40, as indicated by the two arrows 80 in Fig. 2 pointing in the vertical downward direction in Fig. 2. Under the action of the high pressure 80, the penetrator assembly 40 is pushed into the penetration opening 26 of the wall device 20 by the action of axial forces 82, as shown in Fig. 2, which are directed in the downward direction in Fig. 2. Consequently, the face of the first shoulder portion 52, which faces downward in Fig. 2, is pressed against the face of the second shoulder portion 32 of the penetration opening 26, which face faces upward in Fig. 2. The face of the second shoulder portion 32 receives the force 82 exerted axially by the penetrator device 40 due to the high pressure action 80, as the action 84 of the first shoulder portion 52, and creates a counterforce, as the reaction 86 of the second shoulder portion 32, as indicated in Fig. 2. What is important is, that the face of the shoulder portion 32 in the penetration opening 26 carries the total amount of the axial force 82 exerted by the penetrator device 40 via its first shoulder portion 52, and that consequently the weld seam 76 does not have to withstand shearing forces due to any relative axial movement of, or high pressure action 80 exerted on, the high pressure side surfaces (first and third end surfaces 46 and 70) of the penetrator device 40. In result, the cause of microscopic cracks, which is present in the conventional penetrator assembly 100 shown in Figs. 4 and 5 and explained above with reference to Fig. 5 (namely the meaning of the arrows 180, 182 and 184 shown in Fig. 5), is not only alleviated but avoided.

In the first embodiment shown in Figs. 1 and 2, both the second shoulder portion 32 in the inner mantle surface 30 of the penetration opening 26 and the first shoulder portion 52 in the outer mantle surface 50 of the housing 44 of the penetrator device 40 have a flat annular shape.

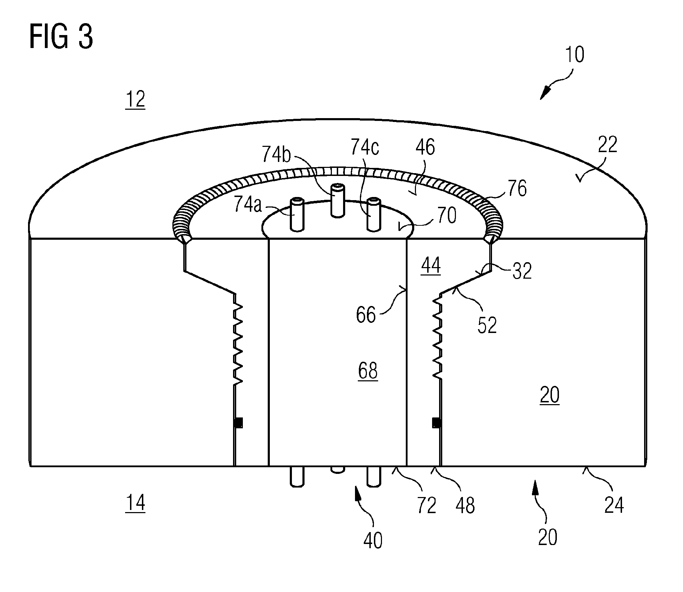

Fig. 3 shows a second embodiment of a penetrator assembly 10. The second embodiment is similar to the first embodiment, except the shape of the first and second shoulder portions 32 and 52. In the second embodiment of the penetrator assembly 10, the shape of the first shoulder portion 52 and the shape of the second shoulder portion 32 are conical.

Irrespective of the particular embodiments, the shape of the second shoulder portion 32 in the inner mantle surface 30 is complementary to the shape of the first shoulder portion 52 on the outer mantle surface 50 of the housing 44.

The wall device 20 is preferably made from steel, namely stainless steel, such as 316 stainless steel, or a corrosion-resistant steel, or may be made from a titanium (Ti) alloy. The housing 44 is made of the same material as the wall device 20. The insert 68 is made of glass or a ceramic material in case the conductor 74 is an electrical conductor, so as to provide good electrical insulation between plural conductors 74a, 74b, 74c. In case the conductors are optical conductors, the insert 68 may be made of an opaque material, such as a ceramic material. An electrical conductor may be a wire having a core made of an electrically conductive metal, such as gold or copper and an electrically isolating sheath surrounding the core. The weld seam 76 may be produced by electron beam welding, so as to melt and then mutually connect the circumferential edges of the first end surface 46 of the housing 44 of the penetrator device 40 and the high pressure environment side surface 22 of the wall device 20.

As concerns the dimensions of the penetrator assembly 10, the diameter of the penetrator device 40 may be in the range from 4 cm to 10 cm, in particular from 6 cm to 7 cm. The length of the penetrator device 40 depends on the difference of the pressures in the high and low pressure environment and may typically be in the range of 3 cm to 7 cm, in particular from 4 cm to 6 cm, and more particular approximately 5 cm.

The side of the high pressure environment 12 of the wall device 20 and of the penetrator device 40 may be exposed to sea water at subsea level, or to an oil, such as a hydraulic oil or an electronic oil, i.e. an oil that is used to shield electronic circuitry.

It should be noted that the term "comprising" does not exclude other elements or steps and "a" or "an" does not exclude a plurality. Also elements described in association with different embodiments may be combined. It should also be noted that reference signs in the claims should not be construed as limiting the scope of the claims.

In order to recapitulate the above described embodiments of the present invention one can state: Disclosed is a penetrator assembly 10 being for high pressure and/or subsea applications and comprising a penetrator device 40 and a wall device 20 having a penetration opening 26 adapted to operatively receive the penetrator device 40, wherein a first flange resp. shoulder portion 52 is provided on the outer mantle surface 50 of the penetrator device 40 and a complementary second flange resp. shoulder portion 32 is provided on the inner mantle surface 30 of the penetration opening 26 of the wall device 26, wherein the second flange or shoulder portion 32 can carry axial forces 84 caused by the action of high pressure 80 on the side of the high pressure environment 12 of the penetrator assembly 10 and transmitted by the penetrator device 40 to the wall device 20 via the first shoulder portion 52 contacting the second shoulder portion 32.

## Claims

1. A penetrator device (40) being for high pressure and/or subsea applications and adapted to be operatively received in a penetration opening (26) of a wall device (20) for high pressure and/or subsea applications and being adapted to conductively penetrate the wall device (20) from a high pressure environment side (12) thereof to a low pressure environment side (14) thereof,
the penetrator device (40) comprising a housing (44) centered around an axis (42) and having a first end surface (46), a second end surface (48) located substantially opposite to the first end surface, and an outer mantle surface (50) adapted to cooperate with an inner mantle surface (30) of the penetration opening (26) of the wall device (20),
wherein the outer mantle surface (50) comprises a shoulder portion (52), at which the radius of the outer mantle surface (50) decreases from a first radius (54) to a second radius (56) that is smaller than the first radius when going axially in the direction toward the second end surface (48), and which is axially located so as to be axially between the high pressure environment side surface (22) and the low pressure environment side surface (24) of the wall device (20), when the penetrator device (40) is operatively received in the penetration opening (26) of the wall device (20).

2. The penetrator device as set forth in claim 1, wherein the outer mantle surface (50) of the housing (44) comprises a threaded portion (58) that is axially located between the first shoulder portion (52) and the second end surface (48) of the housing (44).

3. The penetrator device as set forth in claim 1 or 2, wherein the first shoulder portion (52) has a flat annular shape or a conical shape.

4. The penetrator device as set forth in any one of the claims 1 to 3, wherein the outer mantle surface (50) comprises a circumferential groove (60) that is adapted to receive a circumferential seal (62), such as an O-ring, for sealing against the penetration opening (26) of the wall device (20), when the penetrator device (40) is operatively received in the penetration opening (26) of the wall device (20).

5. The penetrator device as set forth in any one of the claims 1 to 4, wherein the first shoulder portion (52) in the outer mantle surface (50) is complementary to a second shoulder portion (32) provided on inner mantle surface (30) of the penetration opening (26) of the wall device (20).

6. The penetrator device as set forth in any one of the claims 1 to 5, wherein
the housing (44) comprises an inner mantle surface (66) surrounding a passage (64); and
the penetrator device (40) further comprises an insert (68) received in the passage (64) and having a third end surface (70) and a fourth end surface (72) located substantially opposite to the third end surface; and
at least one elongate conductor (74a, 74b, 74c) that is incorporated in the insert (68), extends at least from the third end surface (70) to the fourth end surface (72) and projects from both the third and the fourth end surfaces (70, 72) of the insert (68).

7. A wall device (20) being for high pressure and/or subsea applications and having a penetration opening (26) adapted to operatively receive a penetration device (40) being for high pressure and/or subsea applications and adapted to conductively penetrate the wall device (20) from a high pressure environment side (12) thereof to a low pressure environment side (14) thereof,
wherein the penetration opening (26) is centered around an axis (28), extends from a high pressure environment side surface (22) to a low pressure environment side surface (24), and comprises an inner mantle surface (30);
wherein the inner mantle surface (30) comprises a second shoulder portion (32), at which the radius of the inner mantle surface decreases from a third radius (34) to a fourth radius (36) that is smaller than the third radius when going axially in the direction toward the low pressure side surface (24), and which is axially located between the high pressure environment side surface (22) and the low pressure environment side surface (24).

8. The wall device as set forth in claim 7, wherein the inner mantle surface (30) comprises a threaded portion (38) that is axially located between the shoulder portion (32) and the low pressure environment side surface (24).

9. The wall device as set forth in claim 7 or 8, wherein the second shoulder portion (32) has a flat annular shape or a conical shape.

10. The wall device as set forth in any one of the claims 7 to 9, wherein the second shoulder portion (32) in the inner mantle surface (30) is complementary to a first shoulder portion (52) provided on the outer mantle surface (50) of the housing (44) of the penetrator device (40).

11. Penetrator assembly (10) being for high pressure and/or subsea applications and comprising a wall device (20) as set forth in any one of the claims 7 to 10 and a penetrator device (40) as set forth in any one of the claims 1 to 6,
wherein the penetrator device (40) is operatively received in the penetration opening (26) of the wall device (40) and adapted to conductively penetrate the wall device (20) from a high pressure environment side surface (22) thereof to a low pressure environment side surface (24) thereof.

12. The penetrator assembly as set forth in claim 11, further comprising:
a circumferential seal (62), such as an O-ring, that is received in a circumferential groove (60) in the outer mantle surface (50) of the housing (44) of the penetrator device (40) so as to seal against the inner mantle surface (30) of the penetration opening (26) of the wall device (20), and that is preferably axially located between the shoulder portion (52) of the penetrator device (40) and the low pressure environment side surface (24) of the wall device (20).

13. The penetrator assembly as set forth in claim 11 or 12, further comprising:
a weld seam (76) that is arranged at the high pressure environment side and extends circumferentially so as to bridge the first end surface (46) of the housing (44) of the penetrator device (40) and the high pressure environment side surface (22) of the wall device (20).

14. A method for mounting a penetrator device (40) being for high pressure and/or subsea applications in a penetration opening (26) of a wall device (20) for high pressure and/or subsea applications, wherein the wall device (20) has at least one penetration opening (26) adapted to receive the at least one penetrator device (40) so that the wall device (20) is conductively penetrated from a high pressure environment side surface (22) thereof to a low pressure environment side surface (24) thereof by the at least one penetration device (40), the method comprising the steps of:
(a) providing a wall device (20) comprising a penetration opening (26) that is centered around an axis (28), extends from a high pressure environment side surface (22) to a low pressure environment side surface (24) of the wall device (20), and has an inner mantle surface (30);
(b) producing, on the inner mantle surface (30) of the penetration opening (26), (i) a second shoulder portion (32), at which the radius of the inner mantle surface (30) decreases from a third radius (34) to a fourth radius (36) that is smaller than the third radius (34) when going axially in the direction toward the low pressure side surface (24), and which is axially located between the high pressure environment side surface (22) and the low pressure environment side surface (24), and (ii) a threaded portion (38);
(c) providing a penetrator device (40) comprising a housing (44) centered around an axis (42) and having a first end surface (46), a second end surface (48) located substantially opposite to the first end surface, and an outer mantle surface (50) adapted to cooperate with the inner mantle surface (30) of the penetration opening (26);
(d) producing, on the outer mantle surface (50) of the housing (44) of the penetrator device (40), (iii) a first shoulder portion (52), at which the radius of the outer mantle surface (50) decreases from a first radius (54) to a second radius (56) that is smaller than the first radius when going axially in the direction toward the second end surface (48), and which is axially located so as to be between the high pressure environment side surface (22) and the low pressure environment side surface (24) of the wall device (20), when the penetrator device (40) is operatively received in the penetration opening (26) of the wall device (20), and (iv) a threaded portion;
(e) positioning the penetrator device (40) at the high pressure environment side (12) of the wall device (20) and aligned along the axis (28) of the penetration opening (26) of the wall device (20); and
(f) screwing the penetration device (40) into the penetration opening (26) of the wall device (20), whereby the threaded portion (58) on the outer mantle surface (50) of the housing (44) of the penetrator device (44) engages with the threaded portion (38) on the inner mantle surface (30) of the penetration opening (26), until the first shoulder portion (52) on the outer mantle surface (50) of the penetration device (40) contacts the second shoulder portion (32) on the inner mantle surface (30) of the penetration opening (26).
